(19) Europäisches Patentamt / European Patent Office / Office européen des brevets

(11) **EP 3 345 222 B1**

(12) **EUROPEAN PATENT SPECIFICATION**

(45) Date of publication and mention
of the grant of the patent:
**21.06.2023 Bulletin 2023/25**

(21) Application number: **16757894.7**

(22) Date of filing: **29.08.2016**

(51) International Patent Classification (IPC):
*H01L 31/049* $^{(2014.01)}$   *B32B 27/06* $^{(2006.01)}$
*C08L 23/08* $^{(2006.01)}$   *C08L 43/04* $^{(2006.01)}$

(52) Cooperative Patent Classification (CPC):
**H01L 31/049; B32B 27/08; B32B 27/18;**
**B32B 27/26; B32B 27/32;** B32B 2307/54;
B32B 2307/732; B32B 2457/12; Y02E 10/50

(86) International application number:
**PCT/EP2016/070334**

(87) International publication number:
**WO 2017/037029 (09.03.2017 Gazette 2017/10)**

(54) **POLYETHYLENE COMPOSITION FOR A LAYER ELEMENT OF A PHOTOVOLTAIC MODULE**

POLYETHYLENZUSAMMENSETZUNG FÜR EIN SCHICHTELEMENT EINES
PHOTOVOLTAISCHEN MODULS

COMPOSITION DE POLYÉTHYLÈNE POUR UN ÉLÉMENT EN COUCHE D'UN MODULE
PHOTOVOLTAÏQUE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **03.09.2015 EP 15183610**

(43) Date of publication of application:
**11.07.2018 Bulletin 2018/28**

(73) Proprietor: **Borealis AG**
**1020 Vienna (AT)**

(72) Inventors:
• **HELLSTRÖM, Stefan**
**442 42 Kungälv (SE)**
• **SANDHOLZER, Martina**
**4030 Linz (AT)**
• **SULTAN, Bernt-Åke**
**444 42 Stenungsund (SE)**
• **ANDREASSON, Urban**
**444 95 Ödsmål (SE)**
• **COSTA, Francis**
**4040 Linz (AT)**
• **GALGALI, Girish Suresh**
**4021 Linz (AT)**

(74) Representative: **Maiwald GmbH**
**Elisenhof**
**Elisenstraße 3**
**80335 München (DE)**

(56) References cited:
EP-A1- 2 508 566   EP-A1- 2 803 483
EP-A1- 2 804 223   EP-A1- 2 876 132
GB-A- 2 066 268   US-A- 4 297 310
US-A- 4 413 066   US-A- 4 753 993
US-A1- 2013 209 795

## Description

## Background art

The present invention relates to a backsheet element, to a photovoltaic module comprising at least one photovoltaic element and a backsheet element of the invention and to a use of the polymer composition for producing at least one layer of a backsheet element for a photovoltaic module (PV).

Photovoltaic modules, also known as solar cell modules, produce electricity from light and are used in various kind of applications as well known in the field. The type of the photovoltaic module can vary. The modules have typically a multilayer structure, i.e. several different layer elements which have different functions. The layer elements of the photovoltaic module can vary with respect to layer materials and layer structure. The final photovoltaic module can be rigid or flexible. The rigid photovoltaic module can for example contain a rigid glass top element, front encapsulation layer element, at least one element of photovoltaic cells together with connectors, rear encapsulation layer element, a backsheet layer element and e.g. an aluminum frame. All said terms have a well-known meaning in the art.

In flexible modules the top layer element can be e.g. a fluorinated layer made from polyvinylfluoride (PVF) or polyvinylidenefluoride (PVDF) polymer.

The above exemplified layer elements can be monolayer or multilayer elements. Moreover, there may be adhesive layer(s) between the layers of an element or between the different layer elements.

Backsheet layer element may contain pigmented layer(s). Backsheet element typically provides mechanical and/or insulation properties for the PV module. However, to be noted, also photovoltaic modules with conductive backsheet layer element exist with good mechanical properties, depending on the type of the photovoltaic module.

The prior art backsheet layer is typically a multilayer structure containing e.g. a layer of a fluorinated polymer, e.g. PVF or PVDF, polyamide or polyester. These solutions are costly and many of them have also limited insulation resistance, are easily hydrolysed and give rather high water vapour transmission rates. To compensate the above drawbacks, elements with multilayer structures, typically provided also with adhesive layer(s) between the layers, are needed. The multilayer structures complicate the manufacturing processes and also generate a risk for delamination when in use.

Moreover, photovoltaic cells are typically soldered together, whereby occasionally sharp visible solder peaks may be formed. During lamination of a photovoltaic (PV) module, there must be no risk that solder peaks penetrate the backsheet resulting in a decreased thickness.

WO2013077874 of 3M discloses multilayer element for a photovoltaic module (PV) comprising an insulating layer of crosslinked polyethylene (PE) homo- or copolymers, a back layer (=backsheet layer) of crosslinked polyethylene (PE) homo- or copolymers, and an encapsulating layer. Also polypropylene PP homo- or copolymer option is mentioned. The PE copolymers contain alkene comonomer(s), particularly alpha-olefins. The PE can be LLDPE, LDPE, MDPE and/or HDPE. Back layer can contain pigment, such as carbon black. The insulating layer and back layer can be integrated (coextruded) and preferably crosslinked. According to p.7, crosslinking can be carried out chemically or physically. The chemical crosslinking cross-linkers can be activated thermally, by chemical reaction or by irradiation, which is typically UV- irradiation. Physical crosslinking is carried out by irradiating using α-, β- or e-beam irradiation. Physical irradiation is the preferred crosslinking method. Example 1 discloses a 3-layer backsheet of HDPE/LDPE/HDPE wherein each layer are crosslinked by e-beam irradiation.

EP 2 390 093 A of 3M discloses a multilayer backsheet for a PV comprising an optional top layer, an insulating layer and a back layer, wherein the layers can be PE (LLDPE, LDPE, MDPE and/or HDPE) or PP homo- or copolymers and preferably crosslinked. On p. 7 it is stated that crosslinking can be carried out chemically, e.g. using vinyl-silane, like VTMS, or peroxide as the crosslinking agent, or by irradiation, e.g. using benzophenones and e-beam radiation. The example 1 specify the three layer backsheet element of (HDPE+ white pigment)/LDPE/(HDPE+Carbon black). In examples 2 to 4 flame retardand is additionally added to layers (ii) or (iii). The three layer element was then crosslinked using e-beam irradiation.

EP 2 803 483 A1 discloses a back sheet for a solar battery module including a colored layer that includes three or more types of color materials each having a different hue and a brightness L* of no less than 45, the colored layer having a brightness L' of no greater than 40. EP 2 804 223 A1 discloses a solar cell module produced by laminating at least a back sheet (A) and an encapsulant (B) and a method for producing such a solar cell module. The solar cell module in which the ratio ($\sigma$(A)/G'(B)) of a shrinkage stress ($\sigma$ (A)) (Pa) of the back sheet (A) and a shear elastic modulus (G'(B))(Pa) of the encapsulant (B) at a preset lamination temperature is 60.0 or less. US 2013/209795 A1 discloses a solar module polymer backsheet comprising a basement layer, tie layer on each side of the basement layer, a fourth film layer and a fifth film layer on the other side of the tie layer, the basement layer comprising at least one of the following components: polyamide polymers, polypropylene and propylene polymers, polyethylene and vinyl polymers, poly(vinylidene chloride), styrene polymers, ABS resins, liquid crystal polymers, acrylic polymers, polyphenylene oxides, polycarbonates, and polymer alloys of polycarbonates with poly(C2-6 alkylene glycol phthalates). US 4 413 066 A1 discloses a crosslinkable polyethylene resin composition comprises, basically, (A) a copolymer of ethylene and an ethylenically unsaturated silane compound, wherein the content of the ethylenically unsaturated silane compound unit is 0.001 to 15 percent by weight, and (B) a silanol condensation catalyst. EP 2 508 566 A1 discloses a silane crosslinkable polymer composition which comprises a polyolefin (a) bearing hydrolysable silane group(s) containing units. The polymer composition is suitable for producing crosslinkable articles, preferably one or more layers of a cable.

The technology of the photovoltaic modules is still developing considerably and there is a continuous need for different solutions for instance for backsheet layer elements to meet the various demands in photovoltaic module field.

**Figures**

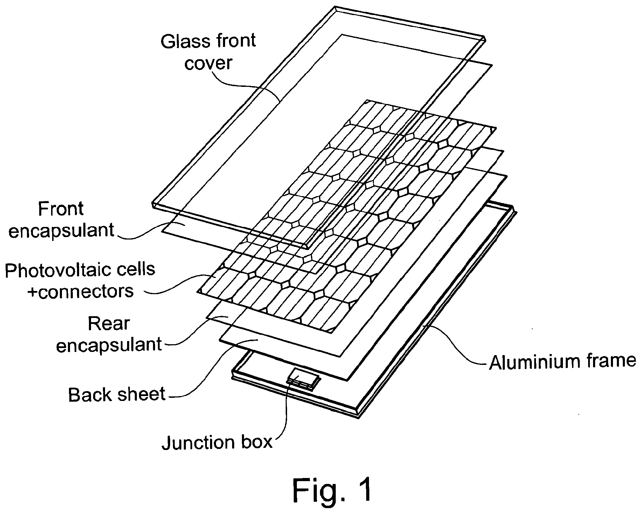

Figure 1 illustrates schematically one example of a photovoltaic module.

**The description of the invention**

The present invention is directed to a photovoltaic module comprising at least one photovoltaic element and at least one back sheet element, the backsheet element comprising at least one layer which comprises a crosslinked polymer composition, which comprises

- a polymer of ethylene (a) which bears functional group(s) containing units; and
- silane group(s) containing units (b);

   wherein the polymer (a) is a polymer of ethylene comprising functional group(s) containing units which are the silane group(s) containing units (b) as comonomer in the polymer of ethylene, and
   wherein the polymer of ethylene (a) is crosslinked via the silane group(s) containing units (b).

The "polymer composition" of the invention as defined above or below is referred herein also shortly as "polymer composition" or "composition". The polymer of ethylene (a) as defined above, below or in claims is referred herein also shortly as "polymer (a)".

"Crosslinked polymer composition" means that at least part of the polymeric component(s) are crosslinked. "Crosslinked" has a very known meaning in the polymer filed. The crosslinking can be effected e.g. using crosslinking agents or irradiation, as well known in the art. The crosslinked polymer composition has a typical network, i.a. interpolymer crosslinks (bridges), as well known in the field.

"At least one layer" is referred herein also shortly as "layer".

The backsheet element of the invention may be a backsheet monolayer element consisting of the "at least one layer" of the invention, or a backsheet multilayer element comprising two or more layers of which at least one layer is the layer of the invention.

The expression "at least one layer" of a backsheet element means that, in case of a backsheet multilayer element, the backsheet element may comprise more than one layer of the invention. Naturally, the PV module may contain also other element(s), like encapsulation element(s), which may comprise a layer(s) comprising the crosslinked polymer composition of the invention.

The "photovoltaic element" means that the element has photovoltaic activity. The photovoltaic element can be e.g. an element of photovoltaic cell(s), which has a well-known meaning in the art. Silicon based material, e.g. crystalline silicon, is a non-limiting example of materials used in photovoltaic cell(s). Crystalline silicon material can vary with respect to crystallinity and crystal size, as well known to a skilled person. Alternatively, the photovoltaic element can be a substrate layer on one surface of which a further layer or deposit with photovoltaic activity is subjected, for example a glass layer, wherein on one side thereof an ink material with photovoltaic activity is printed, or a substrate layer on one side thereof a material with photovoltaic activity is deposited. For instance, in well-known thin film solutions of photovoltaic elements e.g. an ink with photovoltaic activity is printed on one side of a substrate, which is typically a glass substrate. The photovoltaic element is most preferably an element of photovoltaic cell(s).

"Photovoltaic cell(s)" means herein a layer element(s) of photovoltaic cells, as explained above, together with connectors.

The invention is further directed to a use of the polymer composition of the invention for producing at least one layer of a backsheet layer element.

Surprisingly, the polymer of ethylene composition of the invention, wherein the polymer of ethylene (a) is crosslinked via the silane group(s) containing units (b), provides highly advantageous heat resistance properties, even at high temperatures, and at the same time also highly advantageous mechanical properties, which are very useful for a backsheet layer of a photovoltaic module. Accordingly, unexpectedly, the backsheet layer of the invention provides excellent deformation resistance at elevated temperatures, i.e. the layer of the invention maintains substantially the original layer thickness, while e.g. the elongation at break property remains advantageous for the backsheet application. The tensile strength property is also very feasible for backsheet layer applications.

The deformation resistance can be shown e.g. with excellent performance in so called distance through insulation (DTI) test: the thickness of the layer remains substantially unchanged, even when the lamination is effected above the melting temperature of the polymer of ethylene (a).

The unexpected property balance enables, if desired, to produce backsheet elements having reduced layer thickness.

The following preferable embodiments, properties and subgroups of the polymer composition and the components thereof, namely polymer (a), silane group(s) containing units (b), the layer of the backsheet element, the backsheet element and the PV module, including the suitable embodiments thereof, are independently generalisable so that they can be used in any order or combination to further define the suitable embodiments of the polymer composition, the components thereof, the layer of the backsheet, the backsheet and the PV module of the invention.

**Polymer composition, polymer (a) and silane group(s) containing units (b)**

The silane group(s) containing units (b) and the polymer (a) are present as a comonomer of the polymer of ethylene (a).

Copolymerising of silane group(s) containing units is well described in the literature and within the skilles of a skilled person.

In the crosslinked polymer composition of the invention the polymer (a) is crosslinked via the silane group(s) containing units (b).

Furthermore, it is self-evident to a skilled person that the crosslinking degree (=crosslinking level) of the polymer (a), which is crosslinked via the silane group(s) containing units (b), can be varied depending on the degree desired for the backsheet layer in different PV applications. The crosslinking degree can be expressed e.g. as hot set as described below under the "Determination methods".

The silane group(s) containing units (b) are preferably hydrolysable silane group(s) containing units which are crosslinkable.

The polymer (a) is a polymer of ethylene comprising functional group(s) containing units which are the silane group(s) containing units (b). In this embodiment the silane group(s) containing units (b) are copolymerised to the polymer (a). Accordingly, the silane group(s) containing units (b) as the functional groups bearing units are present in said polymer (a) in form of comonomer units. The silane group(s) containing comonomer unit as the silane group(s) containing units (b) is suitably a hydrolysable unsaturated silane compound represented by the formula

$$R^1SiR^2_qY_{3-q} \qquad (I)$$

wherein

$R^1$ is an ethylenically unsaturated hydrocarbyl, hydrocarbyloxy or (meth)acryloxy hydrocarbyl group,
each $R^2$ is independently an aliphatic saturated hydrocarbyl group,
Y which may be the same or different, is a hydrolysable organic group and q is 0, 1 or 2.

Special examples of the unsaturated silane compound (I) are those wherein R1 is vinyl, allyl, isopropenyl, butenyl, cyclohexanyl or gamma-(meth)acryloxy propyl; Y is methoxy, ethoxy, formyloxy, acetoxy, propionyloxy or an alkyl- or arylamino group; and R2, if present, is a methyl, ethyl, propyl, decyl or phenyl group.

Further suitable silane compounds or, preferably, comonomers are e.g. gamma-(meth)acryl-oxypropyl trimethoxysilane, gamma(meth)acryloxypropyl triethoxysilane, and vinyl triacetoxysilane, or combinations of two or more thereof.

As a suitable subgroup of unit of formula (I) is an unsaturated silane compound or, preferably, comonomer of formula (II)

$$CH_2=CHSi(OA)_3 \qquad (II)$$

wherein each A is independently a hydrocarbyl group having 1-8 carbon atoms, suitably 1-4 carbon atoms.

In one embodiment of silane group(s) containing units (b) of the invention, comonomers/compounds of the formula (II) are vinyl trimethoxysilane, vinyl bismethoxyethoxysilane, vinyl triethoxysilane, vinyl trimethoxysilane.

The amount of the silane group(s) containing units (b) present in the polymer composition, preferably in the polymer of ethylene (a), is from 0.01 to 1.00 mol%, suitably from 0.05 to 0.80 mol%, suitably from 0.10 to 0.60 mol%, suitably from 0.10 to 0.50 mol%, when determined according to "Comonomer contents" as described below under "Determination Methods".

Preferably the polymer (a) is a polymer of ethylene with vinyl trimethoxysilane, vinyl bismethoxyethoxysilane, vinyl triethoxysilane or vinyl trimethoxysilane comonomer, preferably with vinyl trimethoxysilane comonomer.

Polymer (a) may contain further comonomer(s) which are different from the comonomer containing said silane group(s) containing units (b). For instance, such further comonomers can be selected from one or more ofC3-C10 alpha-olefins, vinyl esters of monocarboxylic acids, such as acrylate(s), methacrylate(s) or acetate(s), or any mixtures thereof. The optional further comonomer(s) are suitably selected from one of more of acrylate(s), methacrylate(s) and acetate(s) are alkyl acrylates, alkyl methacrylates or vinyl acetate, suitably $C_1$- to $C_6$-alkyl acrylates, $C_1$- to $C_6$-alkyl methacrylates or vinyl acetate, preferably $C_1$- to $C_4$-alkyl acrylates, $C_1$- to $C_4$-alkyl methacrylates. The content of optional comonomer present in the polymer (a) is suitably of 5.0 to 18.0 mol%, when measured according to "Comonomer contents" as described below under the "Determination methods".

Before the crosslinking via the silane group(s) containing units (b) of the polymer (a), the polymer composition, suitably the polymer (a), has preferably $MFR_2$ of at least 0.01, suitably of 0.1 to 15, suitably of 0.2 to 10, suitably of 0.3 to 5, suitably of 0.5 to 3, g/10 min (according to ISO 1133 at 190 °C and at a load of 2.16 kg).

Before the crosslinking via the silane group(s) containing units (b) of the polymer (a), the density of the non-crosslinked polymer (a) is preferably of 900 to 940, suitably of 905 to 940, suitably of 910 to 940, suitably of 915 to 935, suitably of 920 to 935 kg/m$^3$, according to ISO 1872-2.

The crosslinked polymer composition, preferably the crosslinked polymer (a), has suitably Elongation at Break of at least 100% to 700%, suitably of 100 to 500, suitably of 120 to 450,%, when measured according to ISO 527-3 using a film sample as described below under "Determination Methods".

The crosslinked polymer composition, preferably the crosslinked polymer (a), has suitably Tensile Strength of at least 10 MPa, suitably of 12.5 to 50 MPa, when measured according to ISO 527-3 using a film sample as described below under "Determination Methods".

The crosslinked polymer composition, preferably the crosslinked polymer (a), has suitably hot set of less than 200 %, suitably of 5 to 150, suitably of 5 to 100, %, when measured according to Hot set method as described below under "Determination Methods".

The polymer (a) of the layer of the backsheet element of the invention is preferably crosslinked via the silane group(s) containing units (b) using a silanol condensation catalyst (SCC).

"Silanol condensation catalyst (SCC)" means herein chemical compounds that are offered by a supplier specifically for the crosslinking purpose and introduced to the polymer composition before crosslinking for causing the said crosslinking.

The crosslinking is preferably carried out in the presence of silanol condensation catalyst (SCC) and water. Accordingly, the silane group(s) containing units (b) which are present in the polymer (a) are hydrolysed under the influence of water in the presence of the silanol condensation catalyst resulting in the splitting off of alcohol and the formation of silanol groups, which are then crosslinked in a subsequent condensation reaction wherein water is split off and Si-O-Si links are formed between other hydrolysed silane groups present in said polymer (a).

The amount of the silanol condensation catalyst (SCC), if present, is typically 0.00001 to 0.1 mol/kg polymer composition suitably 0.0001 to 0.01 mol/kg polymer composition, more preferably 0.0005 to 0.005 mol/kg polymer composition. The choice of the SCC and the feasible amount thereof depends on the end application and is well within the skills of a skilled person.

It is to be understood that the polymer composition may comprise the SCC before it is used to form a layer of the backsheet element. Alternatively, the SCC may be introduced to the polymer composition after the formation of the at least one layer of a backsheet element. As an example only, in case of e.g. backsheet multilayer element comprising at least one layer of the invention and one or more other layers, then the SCC can be introduced in the other layer adjacent to and in direct contact with said at least one layer of the invention. After formation of the multilayer structure the SCC can then migrate to the at least one layer of the invention to cause the crosslinking of the layer at crosslinking conditions.

The silanol condensation catalyst (SCC) is suitably selected from carboxylates of metals, such as tin, zinc, iron, lead and cobalt; from a titanium compound bearing a group hydrolysable to a Brönsted acid (preferably as described in WO 2011/160964 of Borealis, included herein as reference), from organic bases; from inorganic acids; and from organic acids; suitably from carboxylates of metals, such as tin, zinc, iron, lead and cobalt, from titanium compound bearing a group hydrolysable to a Brönsted acid as defined above or from organic acids, suitably from dibutyl tin dilaurate (DBTL), dioctyl tin dilaurate (DOTL), particularly DOTL; titanium compound bearing a group hydrolysable to a Brönsted acid as defined above; or an aromatic organic sulphonic acid, which is suitably an organic sulphonic acid which comprises the structural element:

$$Ar(SO3H)_x \qquad (II)$$

wherein Ar is an aryl group which may be substituted or non- substituted, and if substituted, then suitably with at least one hydrocarbyl group up to 50 carbon atoms, and x is at least 1; or a precursor of the sulphonic acid of formula (II) including an acid anhydride thereof or a sulphonic acid of formula (II) that has been provided with a hydrolysable protective group(s), e.g. an acetyl group that is removable by hydrolysis. Such organic sulphonic acids are described e.g. in EP 736 065, or alternatively, in EP 1 309 631 and EP 1 309 632.

The sulphonic acid of formula (II) as the SCC may comprise the structural element according to formula (II) one or several times, e.g. two or three times (as a repeating unit (II)). For example, two structural elements according to formula (II) may be linked to each other via a bridging group such as an alkylene group. The sulphonic acid of formula (II) has suitably from 6 to 200 C-atoms, suitably from 7 to 100 C-atoms.

Suitably, in the sulphonic acid of formula (II), x is 1, 2 or 3, suitably x is 1 or 2. Suitably, in the sulphonic acid of formula (II), Ar is a phenyl group, a naphthalene group or an aromatic group comprising three fused rings such as phenantrene and anthracene. Non-limiting examples the sulphonic acid of formula (II) are p-toluene sulphonic acid, 1-naphtalene sulfonic acid, 2-naphtalene sulfonic acid, acetyl p-toluene sulfonate, acetylmethane-sulfonate, dodecyl benzene sulphonic acid, octadecanoyl-methanesulfonate and tetrapropyl benzene sulphonic acid; which each independently can be further substituted. Suitably, the Ar in the sulphonic acid of formula (II) is substituted, i.e. Ar is an aryl group which is substituted with at least one C1 to C30-hydrocarbyl group. Ar is suitably a phenyl group and x is at least one (i.e. phenyl is substituted with at least one -S(=O)2OH), suitably x is 1, 2 or 3; and suitably x is 1 or 2 and Ar is phenyl which is substituted with at least one C3-20-hydrocarbyl group. Examples of suitable sulphonic acid of formula (II) is tetrapropyl benzene sulphonic acid and dodecyl benzene sulphonic acid, more suitably dodecyl benzene sulphonic acid.

Accordingly, in one embodiment the composition of the invention suitably comprises additives other than fillers (like flame retardants (FRs)). Then the composition comprises, based on the total amount (100 wt%) of the composition,

- 90 to 99.9999 wt% of the polymer (a) and
- suitably 0.0001 to 10 wt% of the additives.

The total amount of optional additives is suitably between 0.0001 and 5.0 wt%, like 0.0001 and 2.5 wt%.

The optional additives are suitably conventional additives for photovoltaic module applications, including without limiting to, antioxidants, UV light stabilisers, nucleating agents, clarifiers, brighteners, acid scavengers, as well as slip agents or talc etc. Each additive can be used e.g. in conventional amounts, the total amount of additives present in the propylene composition being preferably as defined above. Such additives are generally commercially available and are described, for example, in "Plastic Additives Handbook", 5th edition, 2001 of Hans Zweifel.

In another embodiment the composition of the invention comprises in addition to the suitable additives as defined above also fillers, such as pigments, FRs with flame retarding amounts or carbon black. Then the composition of the invention comprises, based on the total amount (100wt%) of the composition,

- 30 to 90 wt%, suitably 40 to 70 wt%, of the polymer (a) and
- 10 to 70 wt%, suitably 30 to 60 wt%, of the filler(s) and the suitable additives.

As non-limiting examples, the optional fillers comprise Flame Retardants, such as magensiumhydroxide, ammounium polyphosphate etc.

In one embodiment the polymer composition consists of the polymer (a) as the only polymeric component(s). "Polymeric component(s)" exclude herein any carrier polymers of optional additive or filler products, e.g. master batches of additives or, respectively, filler together with the carrier polymer, optionally present in the composition of the invention. Such optional carrier polymers are calculated to the amount of the respective additive or, respectively, filler based on the amount (100 %) of the composition of the invention.

The polymer (a) of the polymer composition for the backsheet layer of the invention can be e.g. commercially available or can be prepared according to or analogously to known polymerization processes described in the chemical literature.

In a preferable embodiment the polymer (a) is produced by polymerising ethylene with silane group(s) containing comonomer (= silane group(s) containing units (b)) as defined above and optionally with one or more other comonomer(s) in a high pressure (HP) process using free radical polymerization in the presence of one or more initiator(s) and optionally using a chain transfer agent (CTA) to control the MFR of the polymer. The HP reactor can be e.g. a well known tubular or autoclave reactor or a mixture thereof, suitably a tubular reactor. The high pressure (HP) polymerisation and the adjustment of process conditions for further tailoring the other properties of the polyolefin depending on the desired end application are well known and described in the literature, and can readily be used by a skilled person. Suitable polymerisation temperatures range up to 400 °C, suitably from 80 to 350°C and pressure from 70 MPa, suitably 100 to 400 MPa, suitably from 100 to 350 MPa. The high pressure polymerization is generally performed at pressures of 100 to 400 MPa and at temperatures of 80 to 350 °C. Such processes are well known and well documented in the literature and will be further described later below.

The incorporation of the silane group(s) containing units (b) as comonomer (as well as optional other comonomer(s)) and the control of the comonomer feed to obtain the desired final content of said silane group(s) containing units (b) (and of the optional other comonomer(s)) can be carried out in a well known manner and is within the skills of a skilled person.

Further details of the production of ethylene (co)polymers by high pressure radical polymerization can be found i.a. in the Encyclopedia of Polymer Science and Engineering, Vol. 6 (1986), pp 383-410 and Encyclopedia of Materials: Science and Technology, 2001 Elsevier Science Ltd.: "Polyethylene: High-pressure, R.Klimesch, D.Littmann and F.-O. Mähling pp. 7181-7184.

Such HP polymerisation results in a so called low density polymer of ethylene (LDPE) with optional, and preferable, silane group(s) containing comonomer as the silane group(s) containing units (b), and with optional further comonomer(s) as defined above. The term LDPE has a well known meaning in the polymer field and describes the nature of polyethylene produced in HP, i.e the typical features, such as different branching architecture, to distinguish the LDPE from PE produced in the presence of an olefin polymerisation catalyst (also known as a coordination catalyst). Although the term LDPE is an abbreviation for low density polyethylene, the term is understood not to limit the density range, but covers the LDPE-like HP polyethylenes with low, medium and higher densities.

It is preferred that said polymer (a) is produced by higher pressure polymerization.

**Backsheet and PV module**

The at least one layer of the backsheet is a backsheet monolayer element or backsheet multilayer element of a photovoltaic module.

Accordingly, the layer comprises, suitably consists of, the polymer composition, which comprises, suitably consists of, the polymer (a) as the only polymeric component(s).

As mentioned, the polymer (a) is crosslinked via the silane group(s) containing units (b) present in said polymer (a). Then polymer (a) is preferably crosslinked during or after the formation of the layer, preferably after the formation of the at least one layer of the backsheet element. The crosslinking is carried at crosslinking conditions. Crosslinking conditions means conditions enabling the crosslinking to occur to desired crosslinking degree. Suitably the crosslinking is carried out chemically using a catalyst.

The catalyst is preferably a silanol condensation catalyst (SCC). In this embodiment the crosslinking is carried out in the presence of SCC and water (also called as moisture curing). Water can be in form of a liquid or vapour, or a combination thereof. Usually, the moisture curing is performed in ambient conditions or in a so called sauna or water bath at temperatures of 70 to 100 °C.

In embodiments, wherein the backsheet element is a backsheet multilayer element, the layer can be a laminated layer or coextruded layer of said backsheet multilayer element.

As mentioned the backsheet multilayer element comprises one or more additional layers which may be the same as the at least one layer of the invention and/or different from said at least one layer of the invention.

Suitably, the layer of the backsheet monolayer element or the layers of the multilayer backsheet element of the photovoltaic module of the invention is/are free from fluoride containing polymer.

The thickness of the backsheet element is preferably of 180 to 400 $\mu$m, suitably of 200 to 350 $\mu$m, suitably of 220 to 300 $\mu$m.

The PV module of the invention comprises at least one photovoltaic element and at least one layer of a backsheet element of the invention. Furthermore, the PV module of the invention typically comprises further elements, like encapsulation element(s).

As well known, the elements and the layer structure of the photovoltaic module of the invention can vary depending on the desired type of the module. The photovoltaic module can be rigid or flexible.

In one preferable embodiment, the PV module comprises a protective top element, which is typically a glass front sheet (glass front cover), a front encapsulation element (front encapsulant), at least one photovoltaic element (typically photovoltaic cells + connectors), a back encapsulation element (rear encapsulant), the backsheet element of the invention, as defined above, below or in claims, and optionally a protective cover, like a metal frame, such as aluminium frame (with junction box). Moreover, the above elements can be monolayer elements or multilayer elements. Figure 1 illustrates the above embodiment of the photovoltaic module of the invention.

The above photovoltaic module may have further layer element(s) in addition to above mentioned elements. Moreover, the layers of said layer elements may be multilayer elements and comprise also adhesive layers for improving the adhesion of the layers of the multilayer element. There can also be adhesive layers between the different elements, like between the rear encapsulation element and the backsheet element.

Furthermore, the PV module of the invention typically comprises further elements, like encapsulation element(s). Any backsheet multilayer element or any other element may comprise adhesive layer(s) (also known as, for instance, a tie or a sealing layer) between any two layers. There can also be adhesive layer between two functionally different elements. The adhesion layer enhances the adhesion of the adjacent layers or, respectively, of the adjacent elements and typically comprise functionalized, e.g. maleic anhydride (MAH) grafted, polymer component, as well known in the art. The optional adhesive layer may also comprise the composition of the invention, e.g. as a blend with polar components.

In a preferable invention, the optional and preferable functional groups of the polymer (a) of the composition in the at least one layer of the invention are different from anhydride groups, like different from maleic anhydride groups.

The glass layer(s), the photovoltaic element, which is preferably element(s) of photovoltaic cells together with connectors, and further materials for layers for encapsulation element(s) can be e.g. known in the photovoltaic module field and are commercially available or can be produced according to or in accordance with the methods known in the literature for the photovoltaic module field.

The photovoltaic module of the invention can be produced in a manner well known in the field of the photovoltaic modules. The polymeric layer elements including the backsheet element can be produced in a conventional manner for example by coextrusion, like cast film coextrusion, or by lamination, like extruding (casting) a layer on a substrate or laminating premade layers in an laminator equipment at elevated temperature under pressure, using e.g. conventional extruder or laminator equipment.

The different elements of the photovoltaic module are typically assembled together by conventional means to produce the final photovoltaic module. Elements can be provided separately or partly in integrated form to such assembly step. The different elements are then typically attached together by lamination at elevated temperature under pressure using the conventional lamination techniques in the field.

The assembly of photovoltaic module is well known in the field of photovoltaic modules.

## Determination Methods

### Density

The density of the polymer was measured according to ISO 1183-2. The sample preparation was executed according to ISO 1872-2 Table 3 Q (compression moulding).

### Melt Flow Rate

The melt flow rate (MFR) is determined according to ISO 1133 and is indicated in g/10 min. The MFR is an indication of the flowability, and hence the processability, of the polymer. The higher the melt flow rate, the lower the viscosity of the polymer. The $MFR_2$ of polypropylene is measured at a temperature 230 °C and a load of 2.16 kg. The $MFR_2$ of polyethylene is measured at a temperature 190 °C and a load of 2.16 kg

### Comonomer contents:

**The content (wt% and mol%) of silane group(s) containing units (preferably comonomer) present in the polymer composition (preferably in the polymer) and the content (wt% and mol%) of polar comonomer optionally present in the polymer and:** Quantitative nuclear-magnetic resonance (NMR) spectroscopy was used to quantify the comonomer content of the polymer composition or polymer as given above or below in the context.

Quantitative $^1$H NMR spectra recorded in the solution-state using a Bruker Advance III 400 NMR spectrometer operating at 400.15 MHz. All spectra were recorded using a standard broad-band inverse 5 mm probehead at 100°C using nitrogen gas for all pneumatics. Approximately 200 mg of material was dissolved in *1,2*-tetrachloroethane-$d_2$ (TCE-$d_2$) using ditertiarybutylhydroxytoluen (BHT) (CAS 128-37-0) as stabiliser. Standard single-pulse excitation was employed utilising a 30 degree pulse, a relaxation delay of 3 s and no sample rotation. A total of 16 transients were acquired per spectra using 2 dummy scans. A total of 32k data points were collected per FID with a dwell time of 60 $\mu$s, which corresponded to to a spectral window of approx. 20 ppm. The FID was then zero filled to 64k data points and an exponential window function applied with 0.3 Hz line-broadening. This setup was chosen primarily for the ability to resolve the quantitative signals resulting from methylacrylate and vinyltrimethylsiloxane copolymerisation when present in the same polymer.

Quantitative $^1$H NMR spectra were processed, integrated and quantitative properties determined using custom spectral analysis automation programs. All chemical shifts were internally referenced to the residual protonated solvent signal at 5.95 ppm.

When present characteristic signals resulting from the incorporation of vinylacytate (VA), methyl acrylate (MA), butyl acrylate (BA) and vinyltrimethylsiloxane (VTMS), in various comonomer sequences, were observed (Randell89). All comonomer contents calculated with respect to all other monomers present in the polymer.

The vinylacytate (VA) incorporation was quantified using the integral of the signal at 4.84 ppm assigned to the *VA sites, accounting for the number of reporting nuclie per comonomer and correcting for the overlap of the OH protons from BHT when present:

$$VA = (I_{*VA} - (I_{ArBHT})/2) / 1$$

The methylacrylate (MA) incorporation was quantified using the integral of the signal at 3.65 ppm assigned to the 1MA sites, accounting for the number of reporting nuclie per comonomer:

$$MA = I_{1MA} / 3$$

The butylacrylate (BA) incorporation was quantified using the integral of the signal at 4.08 ppm assigned to the 4BA sites, accounting for the number of reporting nuclie per comonomer:

$$BA = I_{4BA} / 2$$

The vinyltrimethylsiloxane incorporation was quantified using the integral of the signal at 3.56 ppm assigned to the 1VTMS sites, accounting for the number of reporting nuclei per comonomer:

$$VTMS = I_{1VTMS} / 9$$

Characteristic signals resulting from the additional use of BHT as stabiliser, were observed. The BHT content was quantified using the integral of the signal at 6.93 ppm assigned to the ArBHT sites, accounting for the number of reporting nuclei per molecule:

$$BHT = I_{ArBHT} / 2$$

The ethylene comonomer content was quantified using the integral of the bulk aliphatic (bulk) signal between 0.00 - 3.00 ppm. This integral may include the 1VA (3) and $\alpha$VA (2) sites from isolated vinylacetate incorporation, *MA and $\alpha$MA sites from isolated methylacrylate incorporation, 1BA (3), 2BA (2), 3BA (2), *BA (1) and $\alpha$BA (2) sites from isolated butylacrylate incorporation, the *VTMS and $\alpha$VTMS sites from isolated vinylsilane incorporation and the aliphatic sites from BHT as well as the sites from polyethylene sequences. The total ethylene comonomer content was calculated based on the bulk integral and compensating for the observed comonomer sequences and BHT:

$$E = (1/4)*[I_{bulk} - 5*VA - 3*MA - 10*BA - 3*VTMS - 21*BHT]$$

It should be noted that half of the $\alpha$ signals in the bulk signal represent ethylene and not comonomer and that an insignificant error is introduced due to the inability to compensate for the two saturated chain ends (S) without associated branch sites.

The total mole fractions of a given monomer (M) in the polymer was calculated as:

$$fM = M / ( E + VA + MA + BA + VTMS )$$

The total comonomer incorporation of a given monomer (M) in mole percent was calculated from the mole fractions in the standard manner:

$$M [mol\%] = 100 * fM$$

The total comonomer incorporation of a given monomer (M) in weight percent was calculated from the mole fractions and molecular weight of the monomer (MW) in the standard manner:

$$M\ [wt\%] = 100 * (fM * MW) / ((fVA * 86.09) + (fMA * 86.09) + (fBA * 128.17) + (fVTMS * 148.23) + ((1\text{-}fVA\text{-}fMA\text{-}fBA\text{-}fVTMS) * 28.05))$$

randall89: J. Randall, Macromol. Sci., Rev. Macromol. Chem. Phys. 1989, C29, 201.

If characteristic signals from other specific chemical species are observed the logic of quantification and/or compensation can be extended in a similar manor to that used for the specifically described chemical species. That is, identification of characteristic signals, quantification by integration of a specific signal or signals, scaling for the number of reported nuclei and compensation in the bulk integral and related calculations. Although this process is specific to the specific chemical species in question the approach is based on the basic principles of quantitative NMR spectroscopy of polymers and thus can be implemented by a person skilled in the art as needed.

Similarly, the optional alpha-olefin comonomer content is quantified using nuclear-magnetic resonance (NMR) spectroscope as defined above and using the well-known principles.

**Tensile Testing: Tensile Modulus; Tensile Strength at break, Elongation at break**:

**Test film sample preparation**:

250 and 330 $\mu$m cast films were prepared on a Plastic Maschinenbau extruder with 3 heating zones equipped with a screw with a diameter of 30 mm, a 200 mm die with a die gap of 0.5 mm. The melt temperature of 200°C and a chill roll temperature of 40°C were used.

The film samples were crosslinked after formation of the film using the catalyst as given below in the experimental part. The crosslinking was effected at ambient temperature, 23°C, and at 50% relative humidity.

The test specimen shall be cut with a film cutter so that the edges are smooth, free from notches and have an exact width. The form of test specimen is a strip 15 mm wide and not less than 150 mm long. The specimens were cut in machine direction.

**Test conditions for film tensile test:**

The test is performed according to ISO 527-3, using the following test condition set:

Test conditions: 23°C / 50% RH
Preload: app. 0,2N
Speed of preload: 2mm/min
Speed of E-Modulus: 1mm/min
Speed of testing: 250mm/min
Clamping distance: 100mm
Start of E-Modulus testing: 0,05%
End of E-Modulus testing: 0,25%

**Preparation of compression moulded plaques for tensile test:**

The test is performed as described above for film samples, except using compression moulded plaques (240mm $\times$ 240mm $\times$ 0.25mm) which were prepared on a machine from Collin (Model: P400 P/M). The temperature and pressure profiles are shown in Table 1.

**Table 1**

|  | Step 1 | Step 2 | Step 3 | Step 4 | Step 5 |
|---|---|---|---|---|---|
| Temperature/ °C | 23 | 200 | 200 | 200 | 23 |
| Time/ sec | 5 | 550 | 600 | 300 | 1100 |
| Pressure/ bar | 3 | 40 | 50 | 100 | 130 |

**Irradiation cross-linking:**

Cross-linking was done using a e-beam irradiation with a dosing of 132 kGy.

**Hot set elongation test:** IEC 60811-2-1 using test film (for inventive examples) or using the moulded test specimens (for comparative example). Both film and moulded test samples were prepared and crosslinked as described above for the Tensile testing under Determination methods.

Each test sample was fixed vertically from upper end thereof in the oven and the load of 0.2 MPa are attached to the lower end of each test sample. After 15 min, 200°C in oven the distance between the pre-marked lines (initial distance 20 mm) were measured and the percentage hot set elongation calculated, elongation %. For permanent set %, the tensile force (weight) was removed from the test samples and after recovered in 200°C for 5 minutes and then let to cool in room temperature to ambient temperature. The permanent set % was calculated from the distance between the marked lines The average of the three test were reported.

**Experimental Part**

Polymer (a) of the invention (inv.polymer):

**Inv.polymer 1**: is a silane copolymer with density of 930 kg/m$^3$, MFR$_2$ of 1.0 g/10min and a vinyl trimethoxy silane (VTMS) content of 1.3wt%.

**Inv.polymer 2**: is a silane copolymer with density of 923 kg/m$^3$, MFR$_2$ of 1.0 g/10min and a vinyl trimethoxy silane (VTMS) content of 1.9wt%.

**Polymerisation method**: the Inventive polymers 1 and 2 were produced in a high pressure tubular reactor in a conventional manner using conventional peroxide initiatior. Ethylene monomer, polar comonomer as identified in table 1 and vinyl trimethoxy silane (VTMS) comonomer (silane group(s) containing comonomer (b)) were added to the reactor system in a conventional manner. CTA was used to regulate MFR as well known for a skilled person. The amount of the vinyl trimethoxy silane units, VTMS, (=silane group(s) containing units), MFR$_2$ and density of the obtained polymers are given in the table 2.

**Table 2**: Process conditions and product properties of Inventive and Comparative Examples

| Test polymer | Inv.polymer 1 | Inv.polymer 2 |
|---|---|---|
| **Polymerisation conditions** | | |
| Pressure, MPa | 290 | 260 |
| Max.temperature | 255 | 305 |
| **Properties of the polymer obtained from the reactor** | | |
| MFR$_{2.16}$, g/10 min | 1.0 | 1.0 |
| Density, kg/m$^3$ | 930 | 923 |
| VTMS content, mol% (wt%) | 0,25 (1.3) | 0,37(1.9) |

The samples for the obtained Inv.polymer 1 and Inv.polymer 2 were produced and crosslinked as described above in Tensile testing method description under Determination methods.

The used film thicknesses and the used silanol condensation catalysts (SCC) for crosslinking are given in table 3.

SCC1: is a silane condensation catalyst which is sulphonic acid

SCC2: is a silane condensation catalyst which is a tin catalyst

**Table 3:**

| Test polymer | Catalyst type and content* | Test Backsheet monolaver, thickness | Test Backsheet monolaver |
|---|---|---|---|
| Inv.polymer 1 | SCC1 2.3x10$^{-3}$ | 250 $\mu$m | Layer 1 |

(continued)

| Test polymer | Catalyst type and content* | Test Backsheet monolayer, thickness | Test Backsheet monolayer |
|---|---|---|---|
| Inv.polymer 2 | SCC1 $4.6 \times 10^{-3}$ | 330 $\mu$m | Layer 2 |
| Inv.polymer 2 | SCC2 $3.2 \times 10^{-3}$ | 330 $\mu$m | Layer 3 |

[0110]   * (mol catalyst / kg polymer composition)

**Table 4:** Crosslinking degree (hot set) and mechanical properties of Layer 1

| Time in ambient conditions | Hotset* | Tensile strength | Elongation at Break |
|---|---|---|---|
| 21 days | 18% | 14.0 MPa | 350% |
| **\* 200°C, 15 min** | | | |

**Table 5:** Crosslinking degree (hot set) and mechanical properties of Layers 2 and 3

| Material | Time in ambient conditions | Hotset* | Tensile strength | Elongation at Break |
|---|---|---|---|---|
| Layer 2 | 6 months | 5% | 15.5 MPa | 130% |
| Layer 3 | 6 months | 9% | 14.5 MPa | 170% |
| **\* 200°C, 15 min** | | | | |

Comparative samples were irradiation crosslinked and non-crosslinked molded test samples prepared as described above in Tensile testing method description under Determination methods.

**Comp.1** was a commercial polyethylene homopolymer (HDPE) having an $MFR_{21}$ of 10.8 g/10 min and a density of 952 kg/m$^3$.

**Comp.2:** was a commercial polyethylene homopolymer as in Comp.1, however without crosslinking (non-crosslinked) .

**Table 6:** Crosslinking degree (hot set) and mechanical properties of the comparative samples

| Comp. Sample | Material | Sample | Irrad. crosslinked | Hotset 15 min | Elongation at Break | Tensile Strength |
|---|---|---|---|---|---|---|
| Comp.1 | HDPE | CP* | Yes | 46% | 7 % | 21 MPa |
| Comp.2 | HDPE | CP* | No | - | 617 % | 30 MPa |
| \* Compressmoulded plaque | | | | | | |

**Distance Through Insulation (DTI) test**: The excellent deformation resistance at elevated temperature is shown with film Layers of the invention compared to Comparative film layer made from the above described HDPE using so called DTI test. Before testing the inventive film layers were crosslinked as described above for Tensile testing under Determination methods. The comparative HDPE layer was e-beam irradiation crosslinked using a dose of 132 kGy: DTI test: On a 60*60 mm piece of float glass of 3 mm thickness , covered by a 50 $\mu$m Teflon sheet, was placed a 10 mm long circular wire with a diameter of 0.8 mm. The wire used was either a solder wire (60 % Sn, 40% Pb) or a tinned steel wire. The wire was covered by an industrial EVA solar encapsulant of 0.45 mm thickness and on top the backsheet layer under investigation. The complete sample was laminated using the conditions given in Table 6.

After lamination, the wire was removed from the backsheet + EVA laminate and a sharp cross-section cut was made using a razor blade and a hammer. The distance through insulation (DTI) was thereafter measured using a light microscope.

**Table 7:** Lamination settings used for DTI test.

| Stage | Duration | Temperature | Upper Pressure |
|---|---|---|---|
| | [s] | [°C] | [mbar] |
| **Evacuation** | 420 | 150 | 0 |
| **Pressure ramp-up** | 45 | 150 | 300 |
| **Pressure ramp-up** | 45 | 150 | 600 |
| **Pressing/Crosslinking** | 720 | 150 | 850 |
| **Ventilation** | 20 | 150 | 0 |

**Table 8** shows the deformation resistance of the inventive layers compared to comparative layer of HDPE

| | Layer 1 | Layer 2 | Layer 3 | Comp 1 | Comp 2 |
|---|---|---|---|---|---|
| **Thickness** | 250 μm | 330 μm | 330 μm | 240 μm | 240 μm |
| **DTI Solder wire** | 250 μm | 330 μm | 320 μm | 220 μm | 0 μm |
| **Difference** | 0% | 0% | -3% | -8% | -100% |
| **DTI Steel wire** | 240 μm | 330 μm | 330 μm | 240 μm | 0 μm |
| **Difference** | -4% | 0% | 0% | 0% | -100% |

A photovoltaic module comprising a front glass layer, EVA-encapsulation layer, photovoltaic element, rear EVA-encapsulation element and the inventive layer 1 as the backsheet element: was produced using the above lamination conditions and backsheet layer thicknesses. The glass and encapsulant materials and thicknesses were as conventionally used in the field of PV modules. The PV module comprised a front glass layer, front encapsulation layer of EVA, conventional photovoltaic element, rear encapsulation layer of EVA and the backsheet of the invention.

## Claims

1. A photovoltaic module comprising at least one photovoltaic element and at least one backsheet element, the backsheet element comprising at least one layer which comprises a crosslinked polymer composition, which comprises

   - a polymer of ethylene (a) which bears functional group(s) containing units; and
   - silane group(s) containing units (b);
   wherein the polymer (a) is a polymer of ethylene comprising functional group(s) containing units which are the silane group(s) containing units (b) as comonomer in the polymer of ethylene, and
   wherein the polymer of ethylene (a) is crosslinked via the silane group(s) containing units (b) .

2. The photovoltaic module according to claim 1, wherein the polymer composition has one or both of the below properties before the crosslinking:

   - MFR$_2$ of at least 0.01 g/10 min according to ISO 1133 at 190 °C and at a load of 2.16 kg, and/or
   - a density of 900 to 940 kg/m$^3$, according to ISO 1872-2 .

3. The photovoltaic module according to claim 1 or claim 2, wherein the crosslinked polymer composition has one or more, in any order, or all of the below properties:

   - Elongation at Break of at least 100% to 700%, when measured according to ISO 527-3 using a film sample as described in the specification under Determination methods,
   - Tensile Strength of at least 10 MPa, when measured according to ISO 527-3 using a film sample as described in the specification under Determination methods, and/or HLZ:LB
   - hot set of less than 200 %, when measured according to Hot set test as described in the specification under Determination methods.

**4.** The photovoltaic module according to any of the preceding claims, wherein the silane group(s) containing comonomer unit as the silane group(s) containing units (b) is a hydrolysable unsaturated silane compound represented by the formula

$$R^1SiR^2_qY_{3-q} \qquad (I)$$

wherein

R$^1$ is an ethylenically unsaturated hydrocarbyl, hydrocarbyloxy or (meth)acryloxy hydrocarbyl group,
each R$^2$ is independently an aliphatic saturated hydrocarbyl group,
Y which may be the same or different, is a hydrolysable organic group and q is 0, 1 or 2.

**5.** The photovoltaic module according to any of the preceding claims, wherein the amount of the silane group(s) containing units (b) present in the polymer composition is from 0.01 to 1.00 mol%, when determined according to "Comonomer contents" as described above under "Determination Methods".

**6.** The photovoltaic module according to any of the preceding claims, wherein the polymer of ethylene (a) is crosslinked via the silane group(s) containing units (b) using a silanol condensation catalyst (SCC).

**7.** The photovoltaic module according to claim 6, wherein the silanol condensation catalyst (SCC) is selected from carboxylates of metals selected from tin, zinc, iron, lead and cobalt, from titanium compound bearing a group hydrolysable to a Brönsted acid or from organic acids selected from aromatic organic sulphonic acids.

**8.** The photovoltaic module according to any of the preceding claims, wherein the thickness of the backsheet element is of 180 to 400 $\mu$m.

**9.** The photovoltaic module according to any of the preceding claims, wherein the backsheet element is a monolayer or a multilayer element.

**10.** A photovoltaic module according to any one of the preceding claims comprising in the given order, a protective top element, a front encapsulation element, at least one photovoltaic element, and a back encapsulation element.

**11.** Use of the polymer composition as defined in any of the preceding claims for producing at least one layer of a backsheet element for a photovoltaic module as defined in any one of the preceding claims.

**Patentansprüche**

**1.** Photovoltaisches Modul, umfassend mindestens ein photovoltaisches Element und mindestens ein Rückwandelement, wobei das Rückwandelement mindestens eine Schicht umfasst, die eine vernetzte Polymerzusammensetzung umfasst, die umfasst

- ein Polymer aus Ethylen (a), das funktionelle Gruppe(n) enthaltende Einheiten trägt; und
- Silangruppe(n) enthaltende Einheiten (b);
wobei das Polymer (a) ein Ethylenpolymer ist, umfassend funktionelle Gruppe(n) enthaltende Einheiten, die die Silangruppe(n) enthaltenden Einheiten (b) als Comonomer in dem Ethylenpolymer sind, und
wobei das Ethylenpolymer (a) über die Silangruppe(n) enthaltenden Einheiten (b) vernetzt ist.

**2.** Photovoltaisches Modul nach Anspruch 1, wobei die Polymerzusammensetzung vor der Vernetzung eine oder beide der nachstehenden Eigenschaften aufweist:

- MFR$_2$ von mindestens 0,01 g/10 min gemäß ISO 1133 bei 190°C und einer Last von 2,16 kg und/oder
- eine Dichte von 900 bis 940 kg/m$^3$ gemäß ISO 1872-2.

**3.** Photovoltaisches Modul nach Anspruch 1 oder Anspruch 2, wobei die vernetzte Polymerzusammensetzung eine oder mehrere, in beliebiger Reihenfolge, oder alle der nachstehenden Eigenschaften aufweist:

- Bruchdehnung von mindestens 100 % bis 700 %, gemessen gemäß ISO 527-3 unter Verwendung einer Folienprobe wie in der Beschreibung unter Bestimmungsverfahren beschrieben,
- Zugfestigkeit von mindestens 10 MPa, gemessen gemäß ISO 527-3 unter Verwendung einer Folienprobe, wie in der Beschreibung unter Bestimmungsverfahren beschrieben, und/oder
- Heißverformung von weniger als 200 %, gemessen gemäß dem Heißverformungstest, wie in der Beschreibung unter Bestimmungsverfahren beschrieben.

4. Photovoltaisches Modul nach einem der vorangehenden Ansprüche, wobei die Silangruppe(n) enthaltende Comomereinheit als die Silangruppe(n) enthaltende(n) Einheit(en) (b) eine hydrolysierbare ungesättigte Silanverbindung ist, wiedergegeben durch die Formel

$$R^1SiR^2_qY_{3-q} \qquad (I)$$

worin

$R^1$ eine ethylenisch ungesättigte Kohlenwasserstoff-, Kohlenwasserstoffoxy- oder (Meth)acryloxy-Kohlenwasserstoffgruppe ist,
jedes $R^2$ unabhängig eine aliphatische gesättigte Kohlenwasserstoffgruppe ist,
Y, das gleich oder verschieden sein kann, eine hydrolysierbare organische Gruppe ist und
q 0, 1 oder 2 ist.

5. Photovoltaisches Modul nach einem der vorangehenden Ansprüche, wobei die Menge der Silangruppe(n) enthaltenden Einheiten (b), die in der Polymerzusammensetzung vorhanden sind, 0,01 bis 1,00 Mol-% beträgt, wenn sie gemäß "Comonomer-Gehalt", wie vorstehend unter "Bestimmungsverfahren" beschrieben, bestimmt wird.

6. Photovoltaisches Modul nach einem der vorangehenden Ansprüche, wobei das Ethylenpolymer (a) über die Silangruppe(n) enthaltenden Einheiten (b) unter Verwendung eines Silanolkondensationskatalysators (SCC) vernetzt ist.

7. Photovoltaisches Modul nach Anspruch 6, wobei der Silanolkondensationskatalysator (SCC) ausgewählt ist aus Carboxylaten von Metallen, ausgewählt aus Zinn, Zink, Eisen, Blei und Kobalt, aus Titanverbindungen, die eine zu einer Brönsted-Säure hydrolysierbare Gruppe tragen, oder aus organischen Säuren, ausgewählt aus aromatischen organischen Sulfonsäuren.

8. Photovoltaisches Modul nach einem der vorangehenden Ansprüche, wobei die Dicke des Rückwandelements 180 bis 400 $\mu$m beträgt.

9. Photovoltaisches Modul nach einem der vorangehenden Ansprüche, wobei das Rückwandelement ein ein- oder mehrschichtiges Element ist.

10. Photovoltaisches Modul nach einem der vorangehenden Ansprüche, umfassend in der angegebenen Reihenfolge ein oberes Schutzelement, ein vorderes Verkapselungselement, mindestens ein photovoltaisches Element und ein hinteres Verkapselungselement.

11. Verwendung der Polymerzusammensetzung, wie in einem der vorangehenden Ansprüche definiert, zur Herstellung mindestens einer Schicht eines Rückwandelements für ein photovoltaisches Modul, wie in einem der vorangehenden Ansprüche definiert.

## Revendications

1. Module photovoltaïque comprenant au moins un élément photovoltaïque et au moins un élément de feuille d'envers, l'élément de feuille d'envers comprenant au moins une couche qui comprend une composition de polymère réticulé, qui comprend

- un polymère d'éthylène (a) qui porte des motifs contenant un ou plusieurs groupes fonctionnels ; et
- des motifs contenant un ou plusieurs groupes silane (b) ;
dans lequel le polymère (a) est un polymère d'éthylène comprenant des motifs contenant un ou plusieurs groupes fonctionnels qui sont les motifs contenant un ou plusieurs groupes silane (b) en tant que comonomère dans le polymère d'éthylène, et

dans lequel le polymère d'éthylène (a) est réticulé via les motifs contenant un ou plusieurs groupes silane (b).

2. Module photovoltaïque selon la revendication 1, dans lequel la composition de polymère à l'une ou les deux des propriétés ci-dessous avant la réticulation :

   - un $MFR_2$ d'au moins 0,01 g/10 min conformément à la norme ISO 1133 à 190°C et sous une charge de 2,16 kg, et/ou
   - une masse volumique de 900 à 940 kg/m$^3$, conformément à la norme ISO 1872-2.

3. Module photovoltaïque selon la revendication 1 ou la revendication 2, dans lequel la composition de polymère réticulé a une ou plusieurs, dans n'importe quel ordre, ou la totalité, des propriétés ci-dessous :

   - un allongement à la rupture d'au moins 100 % à 700 %, quand il est mesuré conformément à la norme ISO 527-3 utilisant un échantillon de film comme décrit dans le fascicule à la rubrique Méthodes de détermination,
   - une résistance à la traction d'au moins 10 MPa, quand elle est mesurée conformément à la norme ISO 527-3 utilisant un échantillon de film comme décrit dans le fascicule à la rubrique Méthodes de détermination, et/ou
   - un allongement à chaud inférieur à 200 %, quand il est mesuré conformément à l'essai d'allongement à chaud tel que décrit dans le fascicule à la rubrique Méthodes de détermination.

4. Module photovoltaïque selon l'une quelconque des revendications précédentes, dans lequel le motif comonomère contenant un ou plusieurs groupes silane constituant les motifs contenant un ou plusieurs groupes silane (b) est un composé silane insaturé hydrolysable représenté par la formule

$$R^1SiR^2_qY_{3-q} \qquad (I)$$

dans laquelle

$R^1$ est un groupe à insaturation éthylénique hydrocarbyle, hydrocarbyloxy ou (méth)acryloxyhydrocarbyle,
chaque $R^2$ est indépendamment un groupe hydrocarbyle saturé aliphatique,
Y, qui peut être identique ou différent, est un groupe organique hydrolysable, et
q vaut 0, 1 ou 2.

5. Module photovoltaïque selon l'une quelconque des revendications précédentes, dans lequel la quantité des motifs contenant un ou plusieurs groupes silane (b) présents dans la composition de polymère est de 0,01 à 1,0 % en moles, quand elle est déterminée conformément à "Teneurs en comonomères" comme décrit ci-dessus à la rubrique "Méthodes de détermination".

6. Module photovoltaïque selon l'une quelconque des revendications précédentes, dans lequel le polymère d'éthylène (a) est réticulé via les motifs contenant un ou plusieurs groupes silane (b) par utilisation d'un catalyseur de condensation de silanol (SCC).

7. Module photovoltaïque selon la revendication 6, dans lequel le catalyseur de condensation de silanol (SCC) est choisi parmi les carboxylates de métaux choisis parmi l'étain, le zinc, le fer, le plomb et le cobalt, parmi les composés du titane portant un groupe hydrolysable vis-à-vis d'un acide de Brönsted ou parmi les acides organiques choisis parmi les acides sulfoniques organiques aromatiques.

8. Module photovoltaïque selon l'une quelconque des revendications précédentes, dans lequel l'épaisseur de l'élément de feuille d'envers est de 180 à 400 $\mu$m.

9. Module photovoltaïque selon l'une quelconque des revendications précédentes, dans lequel l'élément de feuilles d'envers est un élément monocouche ou multicouche.

10. Module photovoltaïque selon l'une quelconque des revendications précédentes, comprenant, dans l'ordre indiqué, un élément supérieur protecteur, un élément d'encapsulation avant, au moins un élément photovoltaïque, et un élément d'encapsulation arrière.

11. Utilisation de la composition de polymère telle que définie dans l'une quelconque des revendications précédentes pour produire au moins une couche d'un élément de feuille d'envers pour un module photovoltaïque tel que défini dans l'une quelconque des revendications précédentes.

Glass front cover

Front encapsulant

Photovoltaic cells +connectors

Rear encapsulant

Back sheet

Junction box

Aluminium frame

Fig. 1

## REFERENCES CITED IN THE DESCRIPTION

### Patent documents cited in the description

- WO 2013077874 A
- EP 2390093 A
- EP 2803483 A1
- EP 2804223 A1
- US 2013209795 A1
- US 4413066 A1
- EP 2508566 A1
- WO 2011160964 A
- EP 736065 A
- EP 1309631 A
- EP 1309632 A

### Non-patent literature cited in the description

- **HANS ZWEIFEL.** Plastic Additives Handbook. 2001
- *Encyclopedia of Polymer Science and Engineering,* 1986, vol. 6, 383-410
- Polyethylene: High-pressure. **R.KLIMESCH ; D.LITTMANN ; F.-O. MÄHLING.** Encyclopedia of Materials: Science and Technology. Elsevier Science Ltd, 2001, 7181-7184
- *CHEMICAL ABSTRACTS,* 128-37-0
- **J. RANDALL.** *Macromol. Sci., Rev. Macromol. Chem. Phys.,* 1989, vol. C29, 201